# EUROPEAN PATENT SPECIFICATION

(11) **EP 3 264 348 B1**
(45) Date of publication and mention of the grant of the patent: **15.04.2020**
(21) Application number: 17177526.5
(22) Date of filing: 22.06.2017
(51) Int. Cl.: G06Q 10/10, G06Q 50/22

(54) **INFORMATION PROCESSING DEVICE, INFORMATION PROCESSING METHOD, AND INFORMATION PROCESSING PROGRAM**
INFORMATIONSVERARBEITUNGSVORRICHTUNG, INFORMATIONSVERARBEITUNGSVERFAHREN UND INFORMATIONSVERARBEITUNGSPROGRAMM
DISPOSITIF DE TRAITEMENT D'INFORMATIONS, PROCÉDÉ DE TRAITEMENT D'INFORMATIONS ET PROGRAMME DE TRAITEMENT D'INFORMATIONS

(30) Priority: 29.06.2016 JP 2016128917
(43) Date of publication of application: 03.01.2018
(73) Proprietor: Fujitsu Limited, Kawasaki-shi, Kanagawa 211-8588 (JP)
(72) Inventor: ITO, Hidenobu, Kawasaki-shi, Kanagawa 211-8588 (JP); NIMURA, Kazuaki, Kawasaki-shi, Kanagawa 211-8588 (JP)
(74) Representative: Haseltine Lake Kempner LLP

(56) References cited:
- EP-A1- 2 739 074
- WO-A1-2016/097381
- US-A1- 2015 035 680
- US-A1- 2015 318 015

## Description

The present disclosure is related to an information processing device, an information processing program, an information processing system, and an information processing method.

In recent years, there has been known a technology for acquiring, from characters input by a keyboard, images acquired by a camera or the like, and so forth, data having specified attributes, thereby automatically inputting the data to a business form, at a time of inputting, to the business form corresponding to a specific equipment, data acquired from this equipment. Patent Literature 4 discloses a system including a wearable device, wherein information is retrieved by the system from sensors based on an activity undertaken by the wearer of the wearable device. Patent Literature 5 discloses a method of using a mobile terminal to control at least one Bluetooth Low Energy, BLE, device, and a corresponding mobile terminal.

### [CITATION LIST]

### [PATENT LITERATURE]

[PATENT LITERATURE 1] Japanese Laid-open Patent Publication No. 2004-213345
[PATENT LITERATURE 2] Japanese Laid-open Patent Publication No. 2009-282622
[PATENT LITERATURE 3] Japanese Laid-open Patent Publication No. 2009-93475
[PATENT LITERATURE 4] WO 2016/097381 A1
[PATENT LITERATURE 5] EP 2 739 074 A1

### TECHNICAL PROBLEM

However, in the related art, to automatically input, to business forms, pieces of data acquired from equipments, a business form has to be developed for each of the equipments, and that process is troublesome. In the related art, to automatically input, to a business form, data acquired from an equipment, an equipment side has to devise measures to acquire the data, or to acquire data from another equipment, a business form program has to be significantly changed, for example.

It is desirable to provide an information processing device, an information processing program, an information processing system, and an information processing method which are each capable of making it easy to dynamically input from various equipments.

### STATEMENT OF INVENTION

The invention is defined by the independent claims. Further aspects of the invention are outlined in the dependent claims. Embodiments which do not fall within the scope of the claims do not describe part of the present invention.

### ADVANTAGEOUS EFFECTS

According to the techniques of the present disclosure, it is easy to dynamically input from various equipments. The invention is described, by way of example, with reference to the following figures, in which:
FIG. 1 is a diagram for explaining an outline of a first embodiment.
FIG. 2 is a diagram for explaining a system configuration of a business form system of the first embodiment.
FIG. 3 is a diagram for explaining an equipment information database of the first embodiment.
FIG. 4 is a diagram for explaining an example of a driver database.
FIG. 5 is a diagram illustrating an example of a hardware configuration of a terminal device of the first embodiment.
FIG. 6 is a diagram for explaining functions of the terminal device of the first embodiment.
FIG. 7 is a flowchart for explaining an operation of the terminal device of the first embodiment.
FIG. 8 is a first diagram for explaining processing in a business form processing unit of the first embodiment.
FIG. 9 is a second diagram for explaining processing in the business form processing unit of the first embodiment.
FIG. 10 is a diagram for explaining functions of a terminal device of a second embodiment.
FIG. 11 is a flowchart for explaining an operation of the terminal device of the second embodiment.
FIG. 12 is a first diagram illustrating an example of a utilization equipment from which additional information is requested.
FIG. 13 is a first diagram for explaining processing in a business form processing unit of the second embodiment.
FIG. 14 is a second diagram illustrating an example of a utilization equipment from which additional information is requested.
FIG. 15 is a second diagram for explaining processing in the business form processing unit of the second embodiment.
FIG. 16 is a diagram for explaining functions of a terminal device of a third embodiment.
FIG. 17 is a flowchart for explaining an operation of the terminal device of the third embodiment.
FIG. 18 is a first diagram illustrating an example of screen definition information in which a usage condition is defined.
FIG. 19 is a diagram for explaining reacquisition of data, performed by a business form processing unit of the third embodiment.
FIG. 20 is a second diagram illustrating an example of screen definition information in which a usage condition is defined.
FIG. 21 is a third diagram illustrating an example of screen definition information in which a usage condition is defined.
FIG. 22 is a diagram for explaining a system configuration of a business form system of a fourth embodiment.
FIG. 23 is a diagram for explaining functions of a business form application distribution unit included in a server device of the fourth embodiment.
FIG. 24 is a flowchart for explaining processing in a business form application distribution processing unit of the fourth embodiment.

### DESCRIPTION OF EMBODIMENTS

### (First Embodiment)

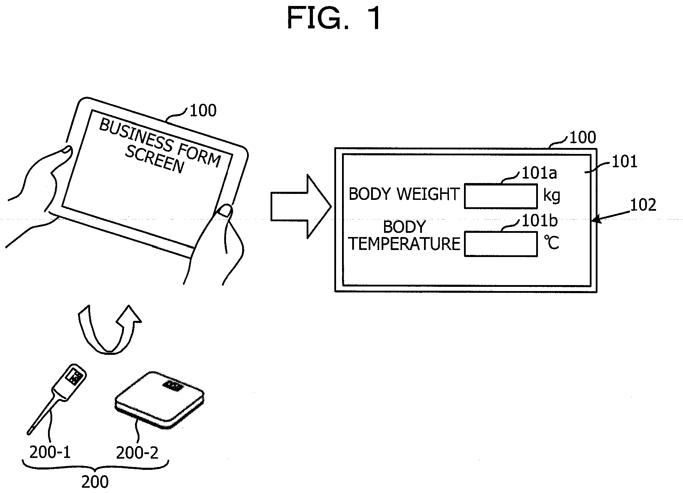

Hereinafter, a first embodiment will be described with reference to drawings. FIG. 1 is a diagram for explaining an outline of the first embodiment.

A terminal device 100 of the present embodiment senses the presences of utilization equipments, based on pieces of equipment information of the respective utilization equipments to be used for acquiring pieces of data, acquires and reads equipment control modules of the respective sensed utilization equipments, and acquires pieces of data from the respective utilization equipments, thereby making it easy to dynamically input from various equipments. By using a business form application installed into the terminal device 100 of the present embodiment, the terminal device 100 realizes the above-mentioned processing.

In the example of FIG. 1, the terminal device 100 acquires pieces of data from, for example, utilization equipments 200-1 and 200-2 and automatically inputs the pieces of data acquired from the respective utilization equipments, to input fields (input columns) of a business form, which correspond to the respective utilization equipments.

In FIG. 1, the utilization equipment 200-1 is a clinical thermometer, and the utilization equipment 200-2 is a body weight scale. In the following explanation, in a case of not being distinguished from each other, the utilization equipments 200-1 and 200-2 are called utilization equipments 200.

In the terminal device 100 of the present embodiment, the business form application includes equipment descriptors for identifying the respective utilization equipments 200-1 and 200-2. Therefore, based on the equipment descriptors of the respective utilization equipments, the terminal device 100 acquires equipment control modules of the respective utilization equipments 200-1 and 200-2, and then injects them into the business form application.

The equipment control modules of the present embodiment are pieces of software desired for causing the utilization equipments to operate and means drivers. In the following explanation, the equipment control modules are called drivers.

Upon injecting the drivers corresponding to the respective utilization equipments, the terminal device 100 causes a display 102 to display an input screen 101 of pieces of data acquired from the respective utilization equipments 200, in accordance with a preliminarily defined screen definition.

The input screen 101 displays thereon an input field 101a of data acquired by the utilization equipment 200-1 and an input field 101b of data acquired by the utilization equipment 200-2 and is a business form type input screen to which pieces of data acquired by the respective utilization equipments are to be input.

In the terminal device 100, data (a body temperature) acquired by the utilization equipment 200-1 is automatically input to the input field 101a. In addition, in the terminal device 100, data (body weight) acquired by the utilization equipment 200-2 is automatically input to the input field 101b.

Accordingly, in a case where a user who holds the terminal device 100 measures a body temperature and body weight by using, for example, the utilization equipment 200-1 and the utilization equipment 200-2, the user oneself does not have to input measurement results to the terminal device 100, and the value of the body temperature and the value of the body weight are each input to a preliminarily defined input field.

As described above, according to the present embodiment, to cause the terminal device 100 to input thereto pieces of data acquired by respective equipments, it is possible to easily input while not preparing business forms for the respective equipments.

Therefore, according to the present embodiment, it is possible to develop business forms without regard to individual equipments, and it is possible to automatically insert desired pieces of data into respective predetermined input fields. In other words, according to the present embodiment, it is possible to provide a business form system capable of handling various equipments.

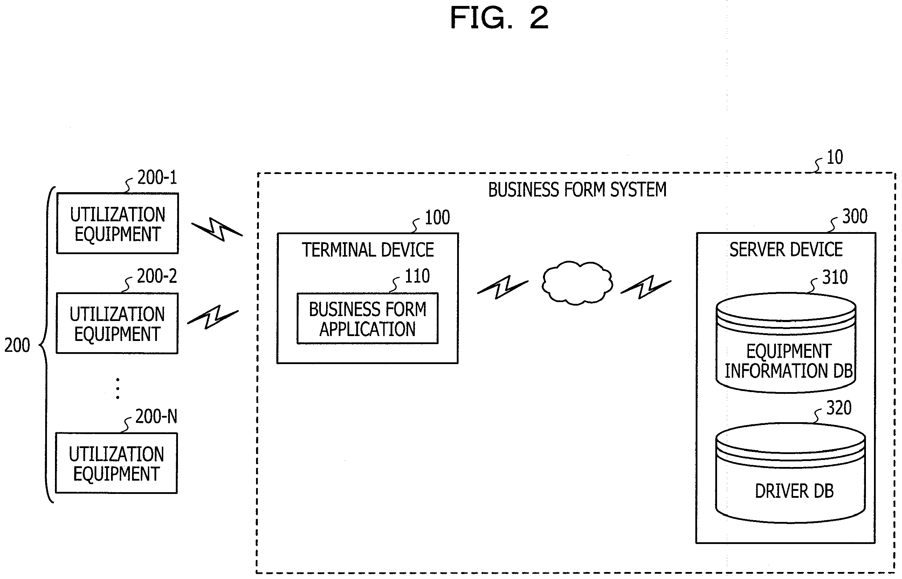

Hereinafter, a business form system of the first embodiment will be described with reference to drawings. FIG. 2 is a diagram for explaining a system configuration of the business form system of the first embodiment.

A business form system 10 of the present embodiment includes the terminal device 100 and a server device 300. A business form application 110 is installed into the terminal device 100 of the present embodiment and inserts pieces of data acquired by the utilization equipment 200-1 to a utilization equipment 200-N, into input fields of a business form screen (input screen) displayed on the terminal device 100. The inserted pieces of data may be stored in various tables or the like included in, for example, the terminal device 100 or may be used for various types of processing in the terminal device 100.

The server device 300 of the present embodiment includes an equipment information database 310 and a driver database 320.

In the equipment information database 310, pieces of equipment information of the respective utilization equipments 200 are stored. Each of the pieces of equipment information is, for example, information including an access destination and so forth at a time of acquiring an equipment control module corresponding to a corresponding one of the utilization equipments 200. In the driver database 320, drivers of the respective utilization equipments 200 are stored.

The equipment information database 310 and the driver database 320 of the present embodiment may be installed in an auxiliary storage device or the like in the server device 300, for example. In addition, the equipment information database 310 and the driver database 320 of the present embodiment may be installed in the terminal device 100.

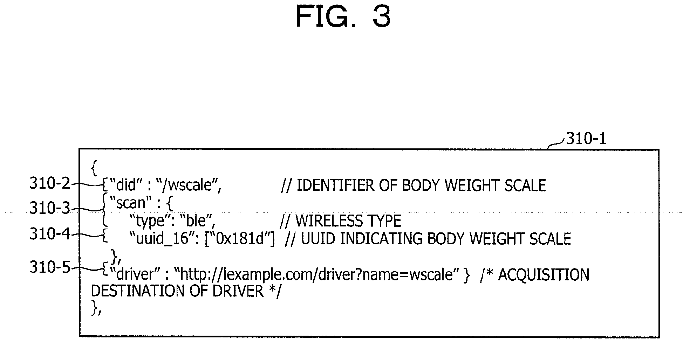

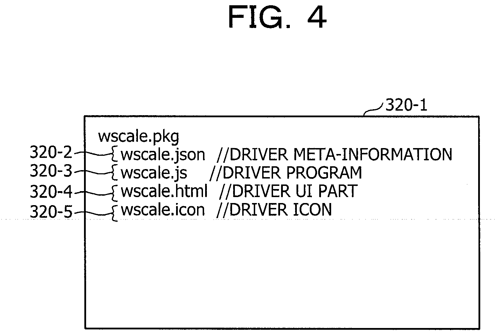

Hereinafter, individual databases included in the server device 300 will be described with reference to FIG. 3 and FIG. 4.

FIG. 3 is a diagram for explaining an equipment information database of the first embodiment. FIG. 3 illustrates an example of equipment information stored in the equipment information database 310.

The equipment information 310-1 illustrated in FIG. 3 is described in a form of associating a key (an item) and the value thereof with each other.

In a description 310-2, the value of did indicates an equipment descriptor for identifying an equipment, and in the description 310-2, an identifier of "/wscale", which indicates a body weight scale, is associated.

In a description 310-3, the value of scan indicates a wireless type used for communication, and in the description 310-3, Bluetooth Low Energy (BLE) is associated as the type.

A description 310-4 indicates field information for identifying a utilization equipment, and in the description 310-4, the field information is uuid_16 and indicates that the value of a field identified by this field information is 0x181d.

In a description 310-5, an acquisition destination of a driver of the utilization equipment corresponding to the equipment descriptor is described.

Note that, in the equipment information 310-1, a value indicating the wireless type may specify a wireless standard such as Bluetooth (registered trademark) or a wireless local area network (LAN), in addition to the BLE. In addition, in the description 310-3, the value of scan may indicate a wired type in a case where communication is performed by using a wired line. The term "wired communication" means communication based on a Universal Serial Bus (USB) or communication based on a wired LAN or the like, for example. In the communication based on the USB, a utilization equipment is identified by a device class, and in a case of the communication based on the wired LAN, a utilization equipment is identified by an IP address.

In addition, in the equipment information 310-1, as the field information for identifying a utilization equipment, a media access control (MAC) address, an access point address, and so forth may be specified in addition to uuid_16.

FIG. 4 is a diagram for explaining an example of a driver database. FIG. 4 illustrates, as an example of driver information, driver information 320-1 stored in the driver database 320.

In the driver information 320-1 illustrated in FIG. 4, a description 320-2 is information in which meta-information of a driver is described. A description 320-3 is a driver program for controlling a corresponding one of the utilization equipments 200. A description 320-4 indicates a screen display part associated with control of the corresponding one of the utilization equipments 200. A description 320-5 indicates a driver icon used for displaying, on a screen, that the presence of the corresponding one of the utilization equipments 200 is sensed.

The driver information of the present embodiment is information obtained by putting the above-mentioned descriptions 320-2, 320-3, 320-4, and 320-5 into one package.

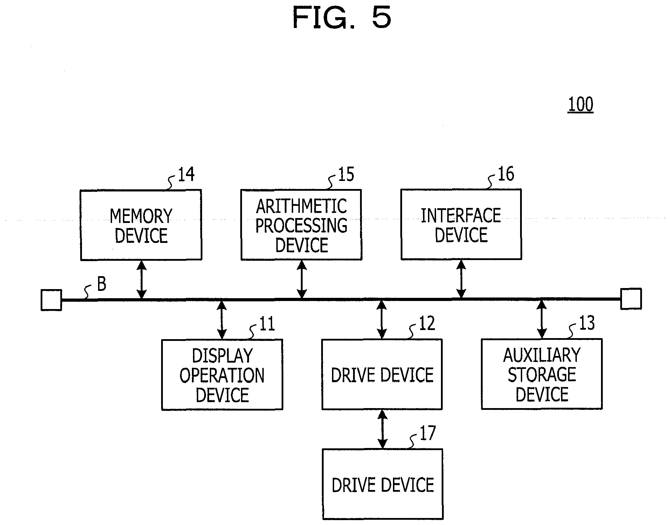

Next, the terminal device 100 of the present embodiment will be described. FIG. 5 is a diagram illustrating an example of a hardware configuration of a terminal device of the first embodiment.

The terminal device 100 of the present embodiment is an information processing device including a display operation device 11, a drive device 12, an auxiliary storage device 13, a memory device 14, an arithmetic processing device 15, and an interface device 16, which are coupled to one another via a bus B.

The display operation device 11 is a touch panel or the like, which realizes functions of inputting various types of information and outputting (displaying) various types of information. The interface device 16 includes a modem, a LAN card, and so forth and is used for being coupled to a network.

The business form application is at least a portion of various programs to control the terminal device 100. The business form application is distributed by distribution of a storage medium 17, downloading from a network, or the like, for example. As the storage medium 17 in which the business form application is recorded, various types of storage medium may be used that include storage media such as a CD-ROM, a flexible disk, and a magneto-optical disk, which each optically, electrically, or magnetically record information, semiconductor memories such as a ROM and a flash memory, which each electrically record information, and so forth.

In addition, in a case where the storage medium 17 in which the business form application is recorded is set in the drive device 12, the business form application is installed to the auxiliary storage device 13 from the storage medium 17 via the drive device 12. The business form application downloaded from the network is installed to the auxiliary storage device 13 via the interface device 16.

The auxiliary storage device 13 stores therein the installed business form application and stores therein desired files, data, and so forth. At a time of activation of a computer, the memory device 14 reads and stores therein the business form application from the auxiliary storage device 13. In addition, in accordance with the business form application stored in the memory device 14, the arithmetic processing device 15 realizes such various types of processing as described later.

In addition, the terminal device 100 of the present embodiment may be a general notebook computer. In that case, in place of the display operation device 11, an input device and an output device may be included therein. In addition, the server device 300 of the present embodiment is a general computer including an arithmetic processing device and a memory device. In addition, since a hardware configuration thereof is the same as that of the terminal device 100 illustrated in FIG. 5, the description thereof will be omitted.

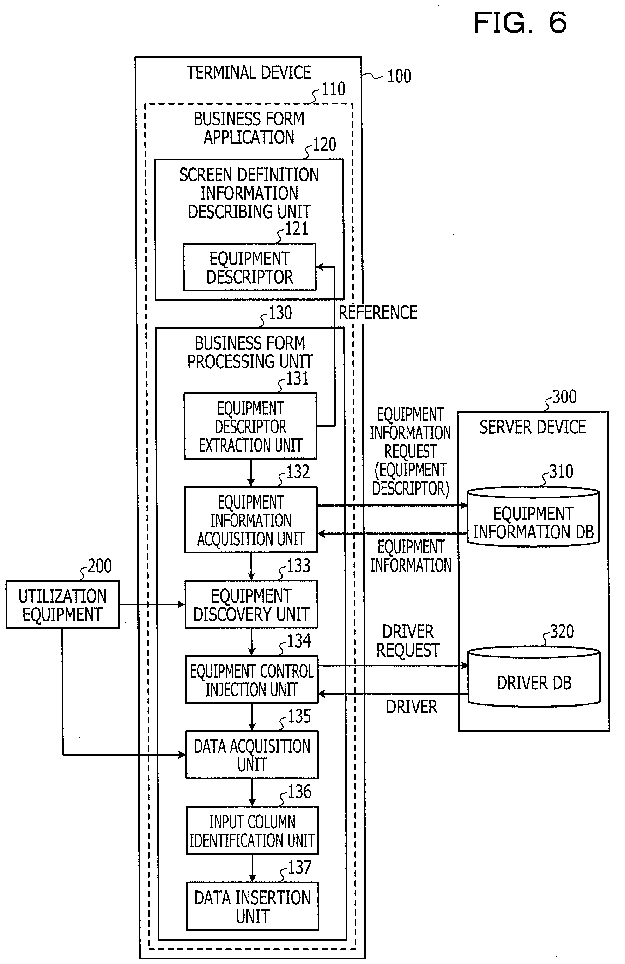

Next, functions of the terminal device 100 of the present embodiment will be described with reference to FIG. 6. FIG. 6 is a diagram for explaining functions of the terminal device of the first embodiment.

The business form application 110 is executed by the arithmetic processing device 15, thereby causing the terminal device 100 of the present embodiment to realize the following functions of respective units.

The business form application 110 of the present embodiment includes a screen definition information describing unit 120 and a business form processing unit 130.

The screen definition information describing unit 120 includes a display method for a business form screen in the terminal device 100 and a description of a layout thereof. The business form processing unit 130 includes descriptions of internal processing of a business form.

Screen definition information described in the screen definition information describing unit 120 of the present embodiment includes an equipment descriptor 121 of one of the utilization equipments 200. In addition, the screen definition information includes specification information for specifying a character string and an input field, which are to be displayed on a screen, an identifier and a name, which are used for identifying each definition information, and the equipment descriptor 121 associated with the screen definition information.

The business form processing unit 130 of the present embodiment includes an equipment descriptor extraction unit 131, an equipment information acquisition unit 132, an equipment discovery unit 133, an equipment control injection unit 134, a data acquisition unit 135, an input column identification unit 136, and a data insertion unit 137.

The equipment descriptor extraction unit 131 extracts the equipment descriptor 121 from the screen definition information. The equipment information acquisition unit 132 searches within the equipment information database 310 by using an equipment descriptor as a key and acquires equipment information used for equipment searching described later.

Based on the acquired equipment information, the equipment discovery unit 133 searches for a utilization equipment located around the terminal device 100 and senses the presence thereof.

The equipment control injection unit 134 references the driver database 320 and acquires a driver (an equipment control module) for controlling the utilization equipment the presence of which is sensed, thereby injecting the driver into the business form application 110 in the terminal device 100. In other words, the equipment control injection unit 134 of the present embodiment dynamically acquires and injects the driver into the business form application 110 in the terminal device 100.

The data acquisition unit 135 transmits, to a corresponding one of the utilization equipments 200, an equipment control instruction by using the driver and acquires data from the corresponding one of the utilization equipments 200.

Based on data input by one of the utilization equipments 200, the input column identification unit 136 identifies an input column in which data is to be input, in a business form screen displayed by the terminal device 100. The data insertion unit 137 inserts the input data into the identified input column.

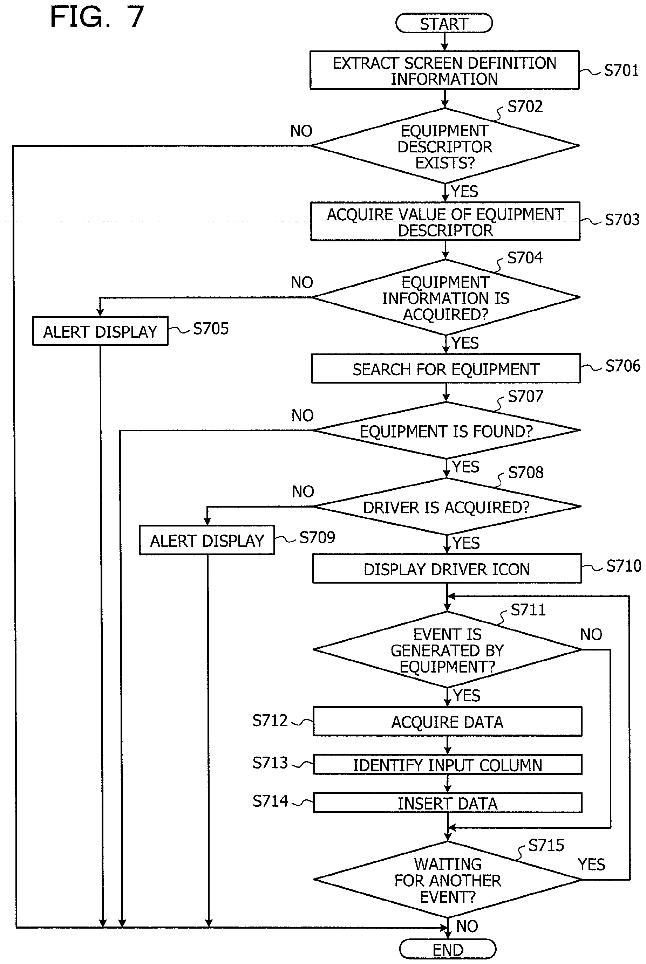

Next, an operation of the terminal device 100 of the present embodiment will be described with reference to FIG. 7. FIG. 7 is a flowchart for explaining an operation of the terminal device of the first embodiment.

In the terminal device 100 of the present embodiment, the equipment descriptor extraction unit 131 extracts the screen definition information from the screen definition information describing unit 120 (step S701). Subsequently, the equipment descriptor extraction unit 131 determines whether or not the equipment descriptor 121 exists in the screen definition information (step S702). In a case where, in step S702, no equipment descriptor 121 exists, the business form processing unit 130 terminates the processing.

In a case where, in step S702, the equipment descriptor 121 exists, the business form processing unit 130 collects the equipment descriptor 121 included in the screen definition information (step S703). Subsequently, in the business form processing unit 130, the equipment information acquisition unit 132 searches within the equipment information database 310 by using the equipment descriptor 121 and determines whether or not corresponding equipment information is acquirable (step S704).

In a case where, in step S704, it is difficult to acquire the corresponding equipment information, the business form processing unit 130 causes the terminal device 100 to display an alert indicating that the corresponding equipment information does not exist in the equipment information database 310 (step S705), and terminates the processing. The alert displayed here may be a message such as "no corresponding equipment information exists", for example.

In a case where, in step S704, the corresponding equipment information is acquired, the business form processing unit 130 searches, by using the equipment discovery unit 133, for one of the utilization equipments 200, indicated by the equipment descriptor 121 (step S706). Subsequently, the equipment discovery unit 133 determines whether or not the corresponding utilization equipment 200 is found (step S707). Details of processing in the equipment discovery unit 133 will be described later.

In a case where, in step S707, the corresponding utilization equipment 200 is not found, the business form processing unit 130 terminates the processing.

In a case where, in step S707, the corresponding utilization equipment 200 is found, the business form processing unit 130 determines whether or not it is possible for the equipment control injection unit 134 to acquire, from the driver database 320, a driver corresponding to the corresponding utilization equipment 200 (step S708). In a case where, in step S708, it is difficult to acquire the corresponding driver, the equipment control injection unit 134 causes an alert to be displayed on a screen of the terminal device 100, the alert informing that "it is difficult to acquire a driver" (step S709), and the equipment control injection unit 134 terminates the processing.

Note that, in the present embodiment, a case where it is difficult to acquire the corresponding driver is a case where no driver exists, a case of failing in receiving a driver, or the like. In the present embodiment, in a case where the corresponding driver is not acquired, a driver icon may be simply inhibited from being displayed while displaying no alert.

In a case where, in step S708, the corresponding driver is acquired, the business form processing unit 130 causes the driver icon to be displayed by using the equipment control injection unit 134 (step S710).

Subsequently, the equipment control injection unit 134 injects individual modules included in the driver into the business form application 110, and then displays the driver icon on the screen, and determines whether or not an event is generated in the corresponding one of the utilization equipments 200 (step S711).

In other words, in step S711, the business form processing unit 130 enters a state of waiting for an event generated by the corresponding one of the utilization equipments 200.

Note that, in the present embodiment, while not automatically entering the event waiting state after displaying the driver icon, the business form processing unit 130 may enter a state of waiting for an event generated by the corresponding one of the utilization equipments 200 after a user explicitly taps the driver icon. By doing so, based on the user's volitional decision, it is possible to determine whether or not to actually use the corresponding one of the utilization equipments 200. Accordingly, in a case where, for example, some of the utilization equipments 200 are found and driver icons are displayed in the terminal device 100, or in a similar case, it is possible to cause the user to select one of the utilization equipments 200 the user wishes to use.

In a case where no event is generated in step S711, the business form processing unit 130 proceeds to step S715 described later.

In a case where an event is generated in step S711, the business form processing unit 130 uses the data acquisition unit 135, thereby acquiring data transmitted by the corresponding one of the utilization equipments 200 (step S712). Note that an event in the corresponding one of the utilization equipments 200 is generated by, for example, an operation performed on the corresponding one of the utilization equipments 200 and data acquired by the corresponding one of the utilization equipments 200 is transmitted to the terminal device 100.

Subsequently, in the business form processing unit 130, upon acquiring data, the input column identification unit 136 extracts an input field from corresponding screen definition information while using the equipment descriptor 121 of the corresponding one of the utilization equipments 200 as a search key and hands over the processing to the data insertion unit 137 (step S713). In other words, the input column identification unit 136 identifies an input field of the data acquired by the data acquisition unit 135.

Subsequently, in the business form processing unit 130, the data insertion unit 137 inserts the acquired data into the identified input field, thereby updating a business form screen (step S714).

Subsequently, the business form processing unit 130 determines whether or not another event for which the business form processing unit 130 waits exists (step S715). In a case where, in step S715, the corresponding event exists, the business form processing unit 130 returns to step S711.

In a case where, in step S715, no corresponding event exists, the business form processing unit 130 terminates the processing.

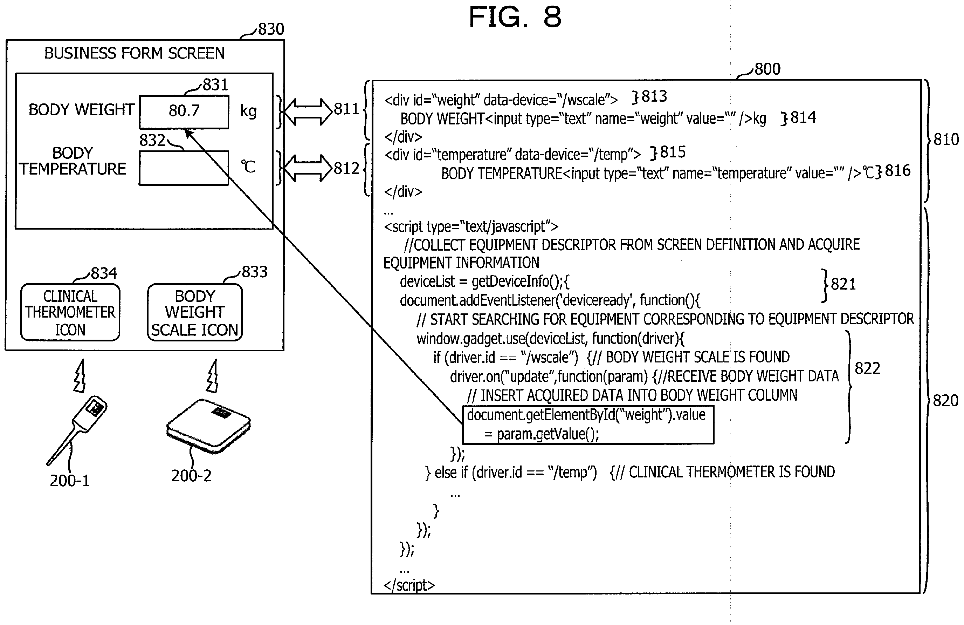

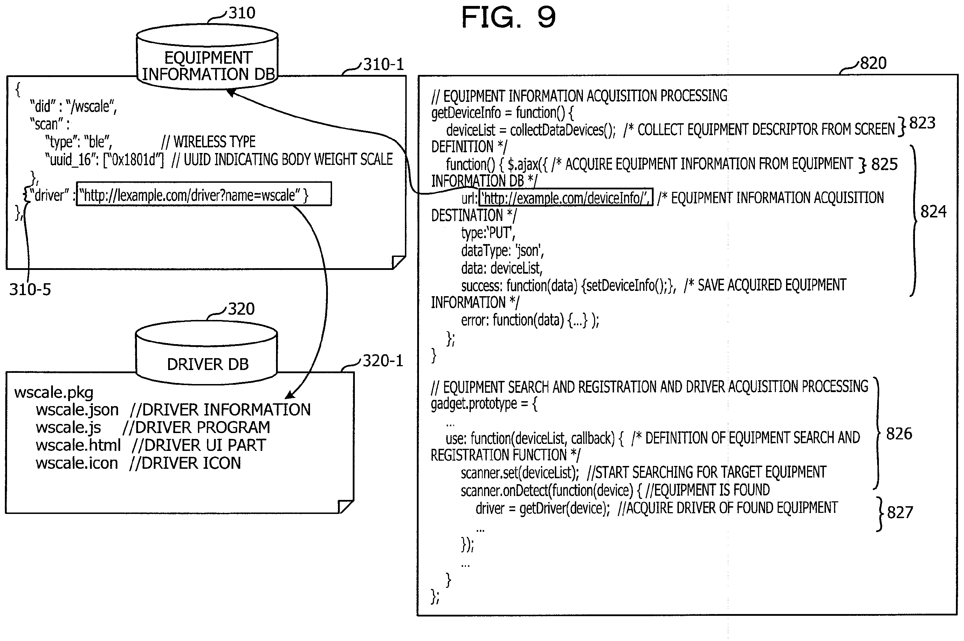

Hereinafter, processing in the business form processing unit 130 of the present embodiment will be specifically described with reference to FIG. 8 and FIG. 9.

FIG. 8 is a first diagram for explaining processing in a business form processing unit of the first embodiment. FIG. 8 illustrates a relationship between pieces of screen definition information and a business form screen 830 displayed in the terminal device 100. Note that a description 800 illustrated in FIG. 8 illustrates an example of a description of the business form application 110 described by a Hyper Text Markup Language (HTML). In addition, a description 810 is an example of the screen definition information, and a description 820 illustrates an example of a description of the business form processing unit 130.

In addition, the business form screen 830 illustrated in FIG. 8 is an example of a business form screen displayed in the terminal device 100. On the business form screen 830, input fields 831 and 832 and icon images 833 and 834 are displayed.

The input field 831 is an input field into which the value of the utilization equipment 200-2 (the body weight scale) is to be input, and the input field 832 is an input field into which the value of the utilization equipment 200-1 (the clinical thermometer) is to be input. The icon image 833 is an icon image of a driver of the utilization equipment 200-1, and the icon image 834 is an icon image of a driver of the utilization equipment 200-2.

In the screen definition information 810, a description 811 defines the input field 831 in the business form screen 830, and a description 812 defines the input field 832 in the business form screen 830.

In addition, in the present embodiment, parts enclosed in <div> tags correspond to the screen definition information 810, the values of id are identifier for identifying respective pieces of screen definition information, and the values of data-device are equipment descriptors of utilization equipments associated with the respective pieces of screen definition information. In a description 813, the value of id is weight, and the value of data-device is /wscale.

In addition, in <div> tags, character strings to be displayed on the business form screen 830 are described. In the example of FIG. 8, these correspond to portions of "body weight", "kg", "body temperature", and "°C". Furthermore, in <div> tags, input fields enclosed in <input> tags are described.

In the <input> tags, type="text" indicates being a text input. In addition, the values of name indicate values for identifying respective input fields, and the values of value each indicate an initial value to be displayed in a corresponding one of the input fields. In the present embodiment, value="" indicates that nothing is displayed in an initial state of a corresponding one of input fields. In a description 814, name="weight" is satisfied, and value="" is satisfied.

In a description 815 in the description 812, the value of id is temperature, and the value of data-device is /temp. In a description 816, name="temperature" is satisfied, and value="" is satisfied.

A description 821 in the description 820 is an example of a description for realizing the equipment descriptor extraction unit 131 and the equipment information acquisition unit 132 in the business form processing unit 130. In addition, a description 822 in the description 820 is an example of a description for realizing the equipment discovery unit 133, the equipment control injection unit 134, the data acquisition unit 135, the input column identification unit 136, and the data insertion unit 137 in the business form processing unit 130.

FIG. 9 is a second diagram for explaining processing in the business form processing unit of the first embodiment. FIG. 9 illustrates examples of descriptions of respective units in the business form processing unit 130.

In the example of FIG. 9, the equipment descriptor extraction unit 131 corresponding to a description 823 collects equipment descriptors of "/wscale" and "/temp" from screen definition information and passes the equipment descriptors to the equipment information acquisition unit 132 corresponding to a description 824.

Note that, in addition to indicating an equipment type, the value of an equipment descriptor of the present embodiment may describe a manufacturer or a type name in hierarchical structure. "/wscale/m_aaa" indicates a body weight scale a manufacturer of which is a m_aaa company, and "/wscale/m_aaa/t_bbb/" indicates a body weight scale a manufacturer of which is the m_aaa company and a model number of which starts with t_bbb, for example.

The equipment information acquisition unit 132 uses the equipment descriptors of "/wscale" and "/temp" as search keys, thereby searching for the equipment information database 310 existing in an access destination indicated by a description 825, and acquires the equipment information 310-1 including the equipment descriptor of "/wscale", for example.

Subsequently, in the business form processing unit 130, the equipment discovery unit 133 corresponding to a description 826 searches for the utilization equipments 200 corresponding to the respective equipment descriptors of "/wscale" and "/temp".

The equipment discovery unit 133 searches for a utilization equipment conformable to a value specified by "scan" included in the equipment information 310-1. The value specified by "scan" indicates a wireless type used for communication.

Upon discovering a utilization equipment, the equipment discovery unit 133 passes, to the equipment control injection unit 134 corresponding to a description 827, an acquisition destination address of a driver corresponding to the description 310-5 of the equipment information 310-1, thereby requesting to acquire the driver.

The equipment control injection unit 134 establishes coupling to a server (the driver database 320) corresponding to the acquisition destination address of the driver and transmits a driver acquisition request. The driver database 320 receives the driver acquisition request and sends back, to the terminal device 100, the driver corresponding to a request content.

In a case where the terminal device 100 acquires the driver, the icon image 833 based on a driver icon included in the driver 320-1 is displayed on the business form screen 830.

In a case where, in this state, an operation is performed on the corresponding one of the utilization equipments 200, the corresponding one of the utilization equipments 200 transmits data and the data acquisition unit 135 detects an event of data reception. In a case of, for example, the body weight scale 200-2, if a person steps thereon, body weight is measured. In addition, in a case where the measurement is completed, the value of the body weight is transmitted as the value of a measurement result according to a specific format. Note that, depending on the utilization equipment 200-2, an advertisement is initiated after the body weight measurement in some cases, and in that case, a procedure of equipment discovery processing is implemented after the body weight measurement.

Upon acquiring data, the business form processing unit 130 inserts this date into an identified input field. Specifically, the value of the description 811 including id="weight" is rewritten with an acquired numerical value. For this reason, in the input field 831 of the business form screen 830, the data acquired from the utilization equipment 200-2 turns out to be automatically displayed.

As described above, according to the present embodiment, in a case of a utilization equipment for which an equipment descriptor is included in screen definition information and for which equipment information desired for injecting a driver is stored in the equipment information database 310, it is possible to cause date to be input in a business form, regardless of the type of utilization equipment.

The equipment descriptor included in the screen definition information and the equipment information stored in the equipment information database 310 may be preliminarily input by an administrator or the like of the business form system 10 of the present embodiment, for example.

As described above, according to the present embodiment, it becomes possible to create business forms without regard to individual equipments, thereby automatically inserting desired pieces of data into respective predetermined input fields. Therefore, it is possible to easily construct a business form system corresponding to various equipments.

### (Second Embodiment)

Hereinafter, a second embodiment will be described with reference to drawings. The second embodiment is different from the first embodiment in that additional information to be referenced at a time of identifying an input field is included in screen definition information. Therefore, in the following description of the second embodiment, only differences from the first embodiment will be described, and the same symbol as that in the description of the first embodiment is assigned to a portion having the same functional configuration as that in the first embodiment, thereby omitting the description thereof.

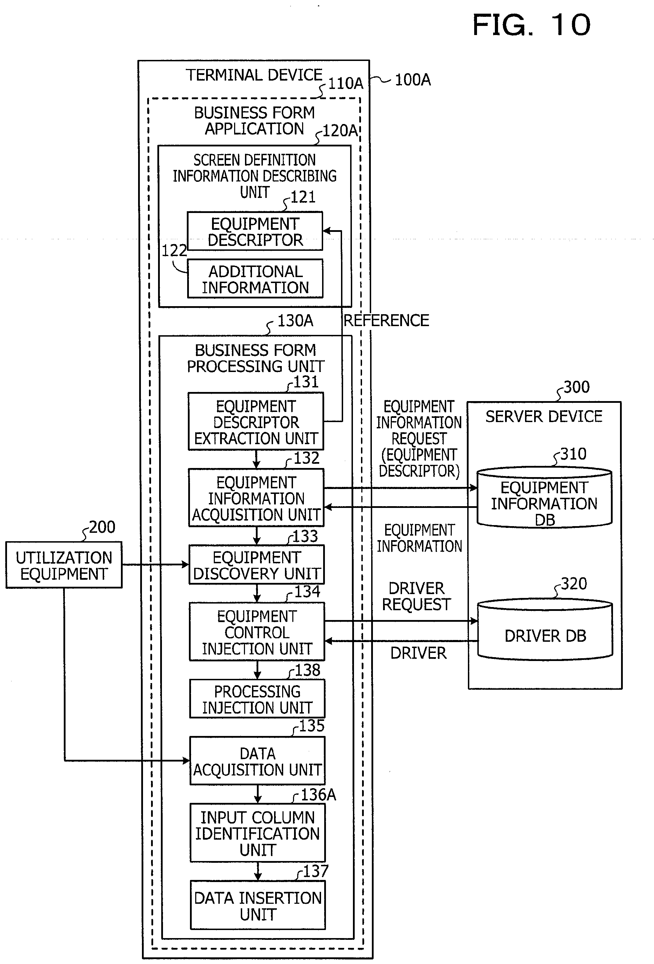

FIG. 10 is a diagram for explaining functions of a terminal device of the second embodiment. In a terminal device 100A of the present embodiment, a business form application 110A is installed.

The business form application 110A of the present embodiment includes a screen definition information describing unit 120A and a business form processing unit 130A.

Screen definition information described in the screen definition information describing unit 120A of the present embodiment includes the equipment descriptor 121 of one of the utilization equipments 200 and additional information 122. The additional information 122 is referenced at a time of acquiring data from the corresponding one of the utilization equipments 200.

The business form processing unit 130A of the present embodiment includes the equipment descriptor extraction unit 131, the equipment information acquisition unit 132, the equipment discovery unit 133, the equipment control injection unit 134, the data acquisition unit 135, an input column identification unit 136A, the data insertion unit 137, and a processing injection unit 138.

Based on the additional information, the input column identification unit 136A of the present embodiment identifies an input field of data.

In a case where a driver is injected by the equipment control injection unit 134, the processing injection unit 138 of the present embodiment causes the driver to perform specified processing. Specifically, the processing injection unit 138 causes the driver to acquire, from the corresponding one of the utilization equipments 200, a value indicated by the additional information. In other words, the processing injection unit 138 instructs the driver to acquire the value indicated by the additional information.

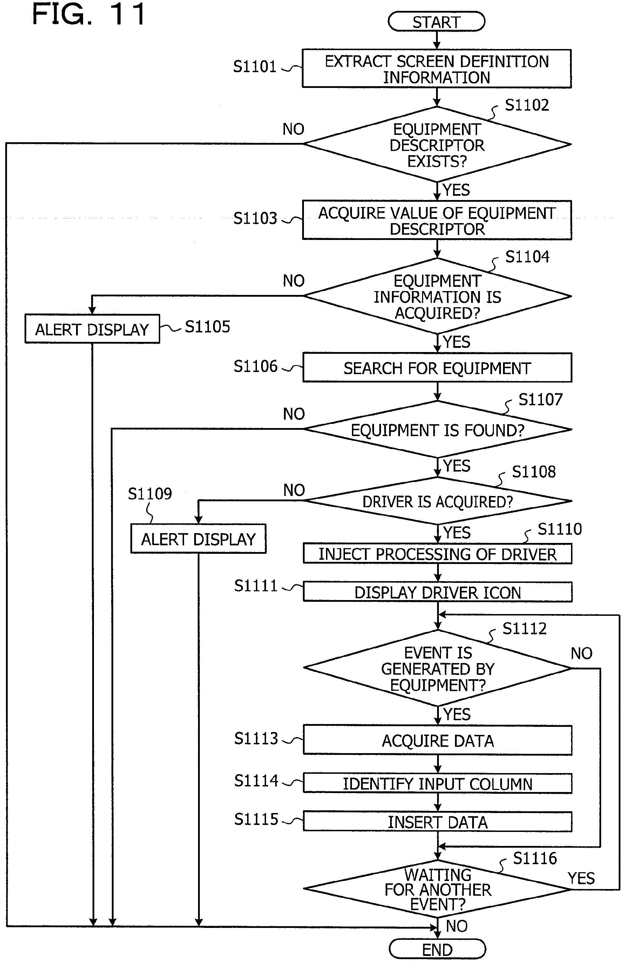

Next, an operation of the terminal device 100A of the second embodiment will be described with reference to FIG. 11. FIG. 11 is a flowchart for explaining an operation of the terminal device of the second embodiment.

Since processing operations in step S1101 to step S1108 in FIG. 11 are the same as the processing operations in step S701 to step S708 in FIG. 7, the descriptions thereof will be omitted.

In a case where, in step S1108, a driver is acquired, the business form processing unit 130A instructs, by using the processing injection unit 138, the driver to perform specified processing (step S1110).

Since processing operations in step S1111 and step S1112 in FIG. 11 are the same as the processing operations in step S710 and step S711 in FIG. 7, the descriptions thereof will be omitted.

In a case where, in step S1112, an event is generated, the data acquisition unit 135 in the business form processing unit 130A acquires data from a corresponding one of the utilization equipments 200 (step S1113). Here, the acquired data includes additional information.

Subsequently, by using the input column identification unit 136A, the business form processing unit 130A references the additional information and identifies an input column into which the data is to be inserted (step S1114).

Since processing operations in step S1115 and step S1116 in FIG. 11 are the same as the processing operations in step S714 and step S715 in FIG. 7, the descriptions thereof will be omitted.

Next, the utilization equipment 200 for which additional information is requested to be referenced at a time of acquiring data will be described.

The utilization equipment 200 for which the additional information is requested to be referenced is a utilization equipment that single-handedly acquires various types of value, for example. In a case where various types of value are acquired from the single utilization equipment, the business form processing unit 130A has to identify a value out of the various types of value, which corresponds to the acquired value, in order to identify an input field at a time of inputting the value in a business form screen.

Therefore, in the present embodiment, in a case of acquiring data from the utilization equipment that single-handedly acquires various types of value, the additional information 122 is caused to be included in the screen definition information.

The additional information 122 of the present embodiment is information to be referenced at a time of associating the acquired data with an input field into which the data is to be input. In other words, the additional information 122 is information for identifying the input field into which the data is to be input.

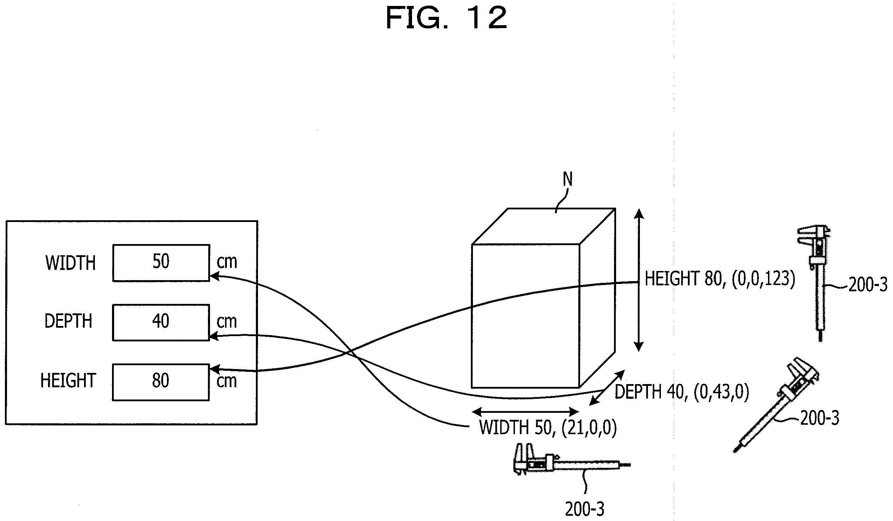

FIG. 12 is a first diagram illustrating an example of a utilization equipment from which additional information is requested. FIG. 12 illustrates an electronic caliper 200-3 serving as an example of a utilization equipment that single-handedly acquires various types of value. In the electronic caliper 200-3, in a case of, for example, measuring a measurement target object N, three types of value of a width, a depth, and a height are acquired as values to be acquired.

The electronic caliper 200-3 is equipped with a triaxial geomagnetic sensor and acquires the values of (x,y,z) coordinates of the triaxial sensor at a time of measuring the measurement target object N. In addition, the electronic caliper 200-3 transmits, to the terminal device 100A, a pair of the value of a measurement result and coordinate values.

Therefore, in a case where the measurement target object N is measured in, for example, a state in which the electronic caliper 200-3 is set upright, values of {80(0,0,123)} are transmitted to the terminal device 100A. In addition, in a case where the measurement target object N is measured in a depth direction thereof in a state in which the electronic caliper 200-3 is turned on its side, values of {40(0,43,0)} are transmitted to the terminal device 100A. In addition, in a case where the width of the measurement target object N is measured in a state in which the electronic caliper 200-3 is turned on its side, values of {50(21,0,0)} are transmitted to the terminal device 100A.

Regarding individual values transmitted to the terminal device 100A, based on it that values other than that of a z-axis, a y-axis, or an x-axis are "0" or values close to "0", it is judged whether a measurement result is a value of the height, the width, or the depth.

Therefore, in a case of inputting the values of the respective width, depth, and height into input fields of a business form screen, the business form processing unit 130A judges whether data (a value) acquired from the utilization equipment 200-3 is a value of the width, the depth, or the height, and identifies an input field serving as an insertion destination. Values referenced for this judgment correspond to the additional information 122 included in the screen definition information.

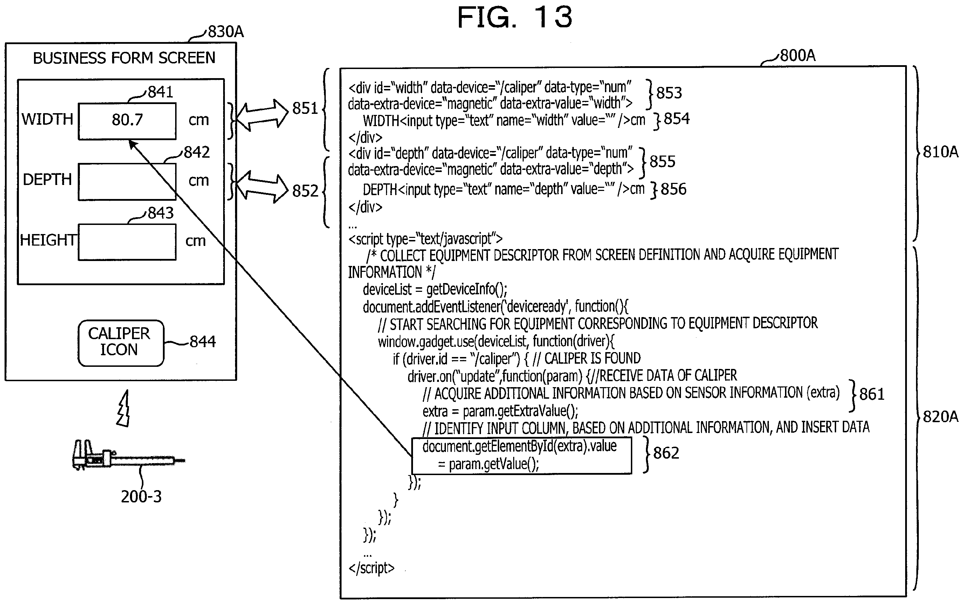

FIG. 13 is a first diagram for explaining processing in a business form processing unit of the second embodiment. A description 800A illustrated in FIG. 13 illustrates an example of a description of the business form application 110A. In addition, a description 810A is an example of the screen definition information, and a description 820A illustrates an example of a description of the business form processing unit 130A.

In addition, a business form screen 830A illustrated in FIG. 13 is an example of a business form screen displayed in the terminal device 100A. On the business form screen 830A, input fields 841, 842, and 843 and an icon image 844 are displayed. The input field 841 is an input field into which the value of the width is inserted, the input field 842 is an input field into which the value of the depth is inserted, and the input field 843 is an input field into which the value of the height is inserted.

In the description 810A indicating the screen definition information of the present embodiment, a description 851 defines the input field 841 in the business form screen 830A, and a description 852 defines the input field 842 in the business form screen 830A.

A description 853 included in the description 851 includes attributes such as "data-extra-device" and "data-extra-value".

The value of "data-extra-device" indicates a device included in a corresponding one of the utilization equipments 200. In other words, the value of "data-extra-device" specifies a device to be used in the corresponding one of the utilization equipments 200. In the example of FIG. 13, it is understood that the value of "data-extra-device" is "magnetic" and specifies the triaxial geomagnetic sensor of the electronic caliper 200-3.

The value of "data-extra-value" indicates the type of data acquired from the corresponding one of the utilization equipments 200. In the example of FIG. 13, it is understood that the value of "data-extra-value" is "width" and the type of the acquired data is the value of the width. In the example of FIG. 13, the value of the attribute of "data-extra-device" and the value of the attribute of "data-extra-value" in the description 810A correspond to the additional information 122.

In addition, in a description 854, "WIDTH" is associated with "width", and the value of "width" is inserted into the input field 841 of the value of the width in the business form screen 830A.

In a description 855 included in the description 852, the value of "data-extra-value" is "depth", and "DEPTH" and "depth" are associated with each other in a description 856. Accordingly, the value of "depth" is inserted into the input field 842 of the value of the depth in the business form screen 830A.

A description 861 included in the description 820A illustrated in FIG. 13 is a description corresponding to the processing injection unit 138. In addition, a description 862 is a description corresponding to the input column identification unit 136A.

In the description 861, by calling a function called param.getExtrValue(), a driver is caused to perform processing for extracting a coordinate value of information acquired from the electronic caliper 200-3 and for classifying the coordinate value into one of three types of "width", "depth", and "high" and is caused to output that result to the business form processing unit 130A. In other words, the processing specified by the processing injection unit 138 is processing for causing the driver to acquire the additional information.

Based on that result, the input column identification unit 136A of the present embodiment determines an input field of data. In a case where the value of extra is "width", for example, the input column identification unit 136A identifies an input field into which data is to be inserted, as an input field of "WIDTH" with which the value of "data-extra-value" coincides.

Note that while, in the above-mentioned example, an example of the utilization equipment 200 that acquires values in the directions of the respective z-axis, y-axis, and x-axis is the electronic caliper 200-3, an example thereof is not limited to this. The utilization equipment 200 that acquires values in the three axial directions may be another equipment such as, for example, an electronic measure.

In this way, in a utilization equipment in which values to be measured vary depending on directions, measured values are automatically inserted into input fields associated with the respective directions in which the measurements are performed. Accordingly, a user of the terminal device 100A does not have to do works such as inputting while checking measured values against input fields corresponding to directions on a business form screen, and it is possible to simplify a work.

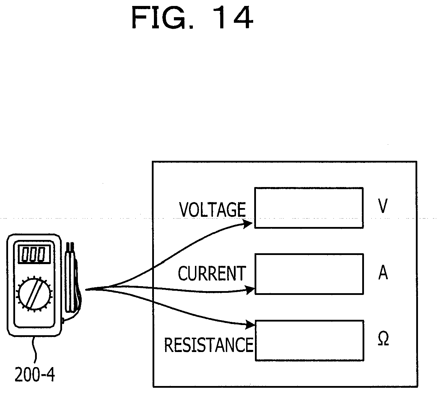

Next, another example of the utilization equipment that single-handedly acquires various types of value will be described with reference to FIG. 14. FIG. 14 is a second diagram illustrating an example of a utilization equipment from which additional information is requested. FIG. 14 illustrates a current-voltage meter 200-4 serving as an example of the utilization equipment that single-handedly acquires various types of value.

The current-voltage meter 200-4 has states (modes). The modes are a voltage measurement mode, a current measurement mode, a resistance measurement mode, and so forth, for example.

In this case, the voltammeter 200-4 performs switching between modes in response to an input field displayed on a business form screen, thereby acquiring data, and inserts the acquired data into the input field.

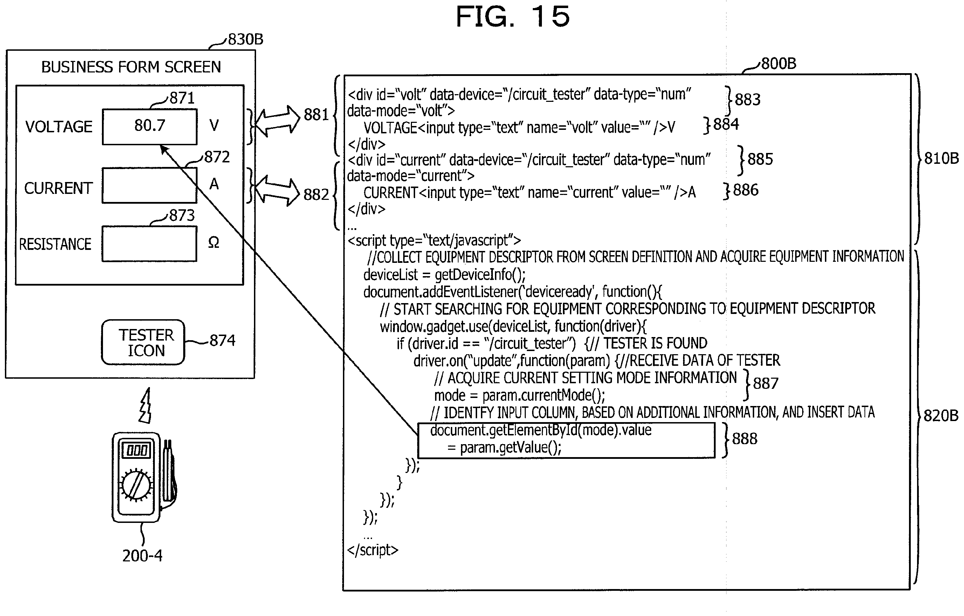

In examples illustrated in FIG. 14 and FIG. 15, it is assumed that information for associating an input field and a mode with each other is the additional information 122.

FIG. 15 is a second diagram for explaining processing in the business form processing unit of the second embodiment. A description 800B illustrated in FIG. 15 illustrates an example of a description of the business form application 110A. In addition, a description 810B is an example of the screen definition information, and a description 820B illustrates an example of a description of the business form processing unit 130A.

In addition, a business form screen 830B illustrated in FIG. 15 is an example of a business form screen displayed in the terminal device 100A. On the business form screen 830B, input fields 871, 872, and 873 and an icon image 874 are displayed. The input field 871 is an input field into which the value of a voltage is inserted, the input field 872 is an input field into which the value of a current is inserted, and the input field 873 is an input field into which the value of resistance is inserted.

In the description 810B indicating the screen definition information of the present embodiment, a description 881 defines the input field 871 in the business form screen 830B, and a description 882 defines the input field 872 in the business form screen 830B.

A description 883 included in the description 881 includes an attribute such as "data-mode". In the example of FIG. 15, the value of the attribute of "data-mode" is the additional information 122. In other words, in the present embodiment, information for indicating a state of a mode set in a corresponding one of the utilization equipments 200 is the additional information 122.

The value of "data-mode" indicates the mode of the corresponding one of the utilization equipments 200. In addition, in a description 884 included in the description 881, "VOLTAGE" and "mode" are associate with each other. Accordingly, a case where the input field 871 is specified in the business form screen 830B indicates that the voltammeter 200-4 is in the voltage measurement mode.

In a description 885 included in the description 882, the value of "data-mode" is "current", and in a description 886, "CURRENT" and "current" are associate with each other. Accordingly, a case where the input field 872 is specified in the business form screen 830B indicates that the voltammeter 200-4 is in the current measurement mode.

In the description 820B in FIG. 15, a description 887 is a description corresponding to the processing injection unit 138. In addition, a description 888 is a description corresponding to the input column identification unit 136A.

In the description 887, upon acquiring data from the current-voltage meter 200-4, a function called param.currentMode() is called, thereby causing a driver to acquire, from the current-voltage meter 200-4, information indicating a mode. In addition, in the description 888, an input field into which the acquired data is to be inserted is identified.

Note that, in the above-mentioned description, upon acquiring data from the current-voltage meter 200-4, the information (additional information) indicating a mode set in the current-voltage meter 200-4 is acquired, thereby identifying, based on the acquired additional information, an input field, a method for identifying an input field is not limited to this.

It is assumed that the input field 871 of the voltage is selected in the business form screen 830B, for example. In this case, the business form processing unit 130A acquires the information indicating a mode from the current-voltage meter 200-4 by using the driver and determines whether or not the mode of the current-voltage meter 200-4 is the voltage measurement mode. In a case of the voltage measurement mode, the business form processing unit 130A only has to insert, into the input field 871, data acquired from the current-voltage meter 200-4. In addition, in a case where the mode of the current-voltage meter 200-4 is not the voltage measurement mode, the business form processing unit 130A causes the driver to set the current-voltage meter 200-4 to the voltage measurement mode.

While, in the above-mentioned example, an example of the utilization equipment 200 having the modes is the current-voltage meter 200-4, the example thereof is not limited to this. The present embodiment may be applied to any equipment as long as the equipment is the utilization equipment 200 having the modes.

As described above, according to the present embodiment, for a utilization equipment serving as an equipment that single-handedly measures various types of value, it is possible to insert acquired data into an input field corresponding to the data.

### (Third Embodiment)

Hereinafter, a third embodiment will be described with reference to drawings. The third embodiment is different from the first embodiment in that a usage condition of a utilization equipment is included in screen definition information. Therefore, in the following description of the third embodiment, only differences from the first embodiment will be described, and the same symbol as that in the description of the first embodiment is assigned to a portion having the same functional configuration as that in the first embodiment, thereby omitting the description thereof.

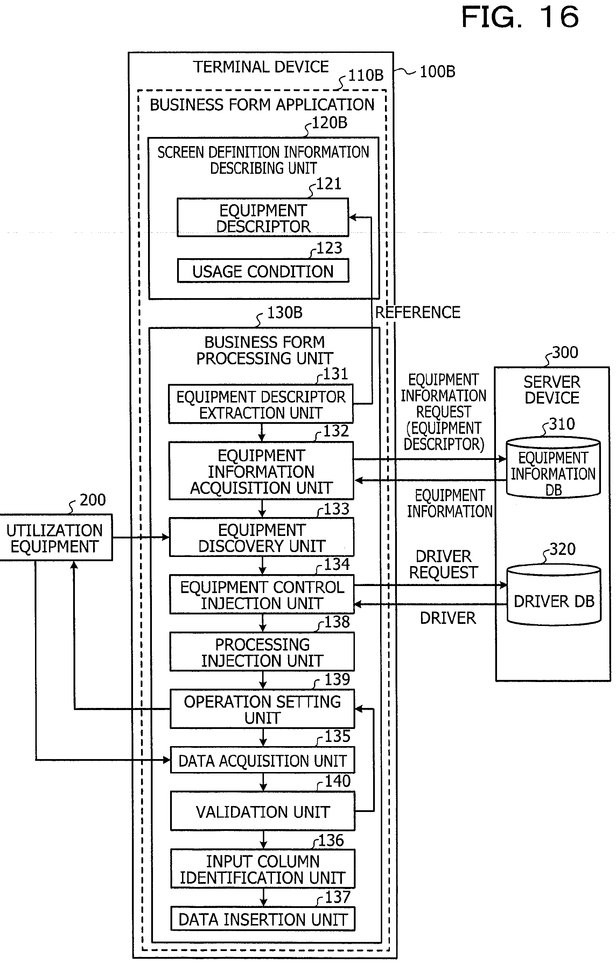

FIG. 16 is a diagram for explaining functions of a terminal device of the third embodiment. In a terminal device 100B of the present embodiment, a business form application 110B is installed.

The business form application 110B of the present embodiment includes a screen definition information describing unit 120B and a business form processing unit 130B.

Screen definition information described in the screen definition information describing unit 120B of the present embodiment includes the equipment descriptor 121 of one of the utilization equipments 200 and a usage condition 123.

The usage condition 123 of the present embodiment includes various kinds of conditions related to the usage of the corresponding one of the utilization equipments 200. Specifically, the usage condition may be a condition for data acquired by the corresponding one of the utilization equipments 200 or may be a condition used by the corresponding one of the utilization equipments 200 to start acquisition of data. In other words, the usage condition 123 of the present embodiment is a condition related to acquisition of data from the corresponding one of the utilization equipments 200.

The business form processing unit 130B of the present embodiment includes the equipment descriptor extraction unit 131, the equipment information acquisition unit 132, the equipment discovery unit 133, the equipment control injection unit 134, the data acquisition unit 135, the input column identification unit 136, the data insertion unit 137, the processing injection unit 138, an operation setting unit 139, and a validation unit 140.

By using a driver, the operation setting unit 139 of the present embodiment causes the corresponding one of the utilization equipments 200 to perform a predetermined operation. In other words, the operation setting unit 139 instructs the driver to perform processing for causing a specified operation to be performed in the corresponding one of the utilization equipments 200.

The validation unit 140 determines whether or not data acquired by the data acquisition unit 135 is valid data. Specifically, the validation unit 140 determines whether or not the data acquired by the data acquisition unit 135 satisfies the usage condition.

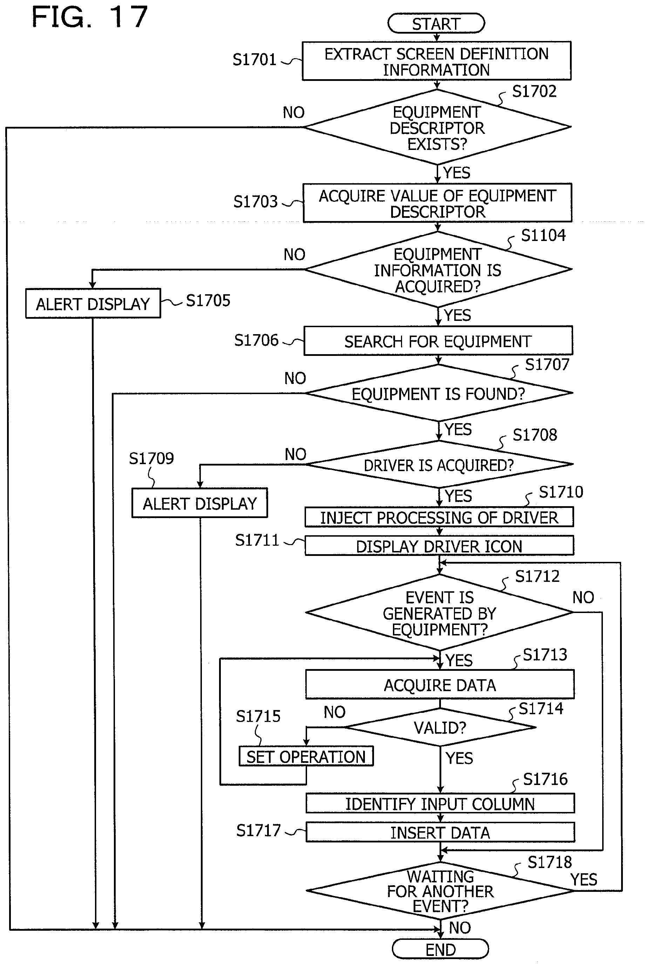

Next, an operation of the terminal device 100B of the third embodiment will be described with reference to FIG. 17. FIG. 17 is a flowchart for explaining an operation of the terminal device of the third embodiment.

Since processing operations in step S1701 to step S1713 in FIG. 17 are the same as the processing operations in step S1101 to step S1113 in FIG. 11, the descriptions thereof will be omitted.

In a case where data is acquired in step S1713, the business form processing unit 130B determines, by using the validation unit 140, whether or not the usage condition 123 included in the screen definition information is satisfied (step S1714). In a case where, in step S1714, the acquired data does not satisfy the usage condition 123, the business form processing unit 130B sets a predetermined operation in a corresponding one of the utilization equipments 200 by using the operation setting unit 139 (step S1715) and returns to step S1713.

The predetermined operation is an operation such as measuring a value again.

In a case where, in step S1714, the acquired data satisfies the usage condition 123, the business form processing unit 130B identifies, by using the input column identification unit 136, an input field of the acquired data (step S1716). Since processing operations in step S1716 to step S1718 are the same as the processing operations in step S1114 to step S1116 in FIG. 11, the descriptions thereof will be omitted.

Note that, in the example of FIG. 17, it is assumed that, in a case where the acquired data does not satisfy the usage condition 123, the operation setting unit 139 performs a setting of an operation for the corresponding one of the utilization equipments 200, there is no limitation to this. After a driver is injected, for example, and before acquiring data, the operation setting unit 139 may set an operation for the corresponding one of the utilization equipments 200, in order to put the corresponding one of the utilization equipments 200 into a predetermined state.

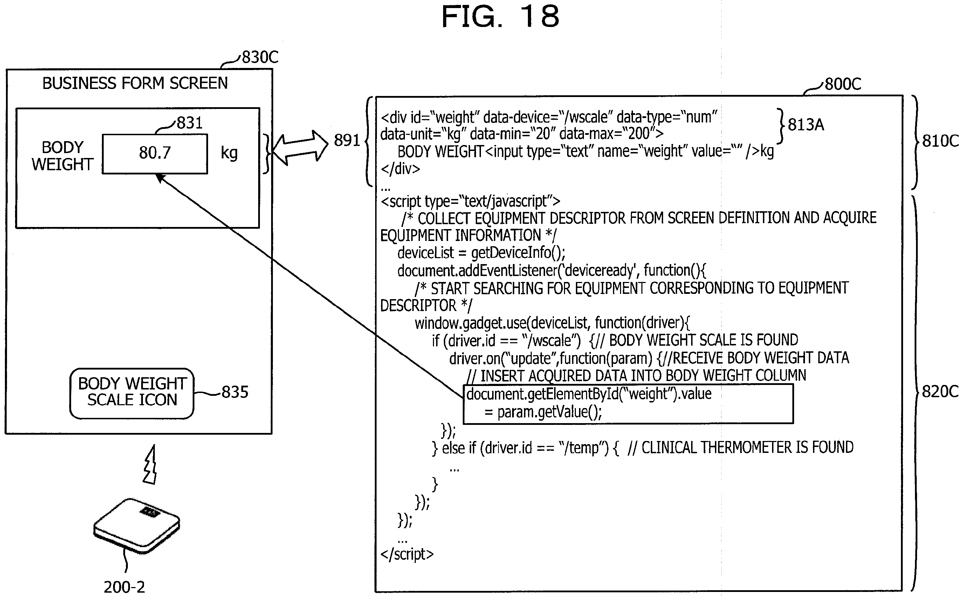

Hereinafter, an example in which the usage condition 123 is defined in the screen definition information describing unit 120B will be described with reference to FIG. 18 to FIG. 21.

FIG. 18 is a first diagram illustrating an example of screen definition information in which a usage condition is defined. It is assumed that the utilization equipment 200-5 illustrated in FIG. 18 is a body weight scale capable of switching the display of a unit between "Kg" and "Ib". In addition, it is assumed that, in the utilization equipment 200-5, data is acquired in a state of specifying the display of a unit as "Kg".

A description 800C illustrated in FIG. 18 illustrates an example of a description of the business form application 110B. In addition, a description 810C is an example of the screen definition information, and a description 820C illustrates an example of a description of the business form processing unit 130B.

In addition, a business form screen 830C illustrated in FIG. 18 is an example of a business form screen displayed in the terminal device 100B. On the business form screen 830C, the input field 831 and an icon image 835 are displayed. The input field 831 is an input field into which the value of the utilization equipment 200-5 is inserted. In the description 810C indicating the screen definition information of the present embodiment, a description 891 defines the input field 831 in the business form screen 830C.

A description 813A included in the description 891 includes attributes such as "data-unit" and "data-min/data-max".

The value of "data-unit" is a value indicating the unit of data and is transmitted to the utilization equipment 200-5. The values of "data-min/data-max" indicate a minimum value and a maximum value of the data acquired from the utilization equipment 200-5. In the present embodiment, in a case where the value of the data is less than or equal to the value of data-min or is greater than or equal to the value of data-max, data is acquired again.

Accordingly, in the present embodiment, the value of "data-unit" and the values of "data-min/data-max" correspond to the usage condition 123.

In the description 813A illustrated in FIG. 18, a unit is "Kg". Therefore, before acquiring data from the utilization equipment 200-5, the business form processing unit 130B causes a driver to perform processing for causing the operation setting unit 139 to perform a setting in the utilization equipment 200-5 so as to acquire data based on the unit of "Kg".

In addition, in the description 813A, in a case where data is less than or equal to "20" or is greater than or equal to "200", the business form processing unit 130B causes, by using the operation setting unit 139, the utilization equipment 200-5 to acquire data again, thereby reacquiring data.

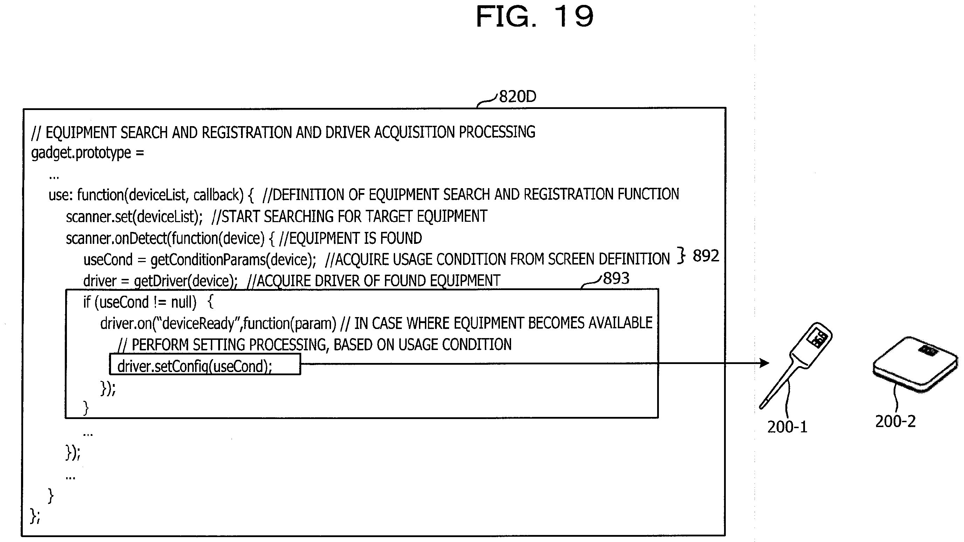

Hereinafter, reacquisition of data will be described with reference to FIG. 19. FIG. 19 is a diagram for explaining reacquisition of data, performed by a business form processing unit of the third embodiment.

In a description 820D illustrated in FIG. 19, a description 892 is an example of a description corresponding to the operation setting unit 139. In the example of FIG. 19, processing for passing a value specified by data-unit is added to calling of a drivrt.set.Config(useCond) function.

In the example of FIG. 19, by adding this description, it is possible to cause the driver to perform processing for causing the utilization equipment 200-5 to set "Kg" as the unit of data.

Note that the driver of the present embodiment may be equipped with a function of causing, as part of error processing, the utilization equipment 200-5 to acquire data again in a case where data is less than or equal to 20 Kg or is greater than or equal to 200 Kg, for example.

In this case, the function of performing the error processing may be added to the driver by the administrator or the like of the business form system 10 in a case where the equipment control injection unit 134 acquires the driver, for example. In addition, the function of performing the error processing may be preliminarily included in the driver. In this case, the driver equipped with the function of performing the error processing turns out to be stored in the driver database 320.

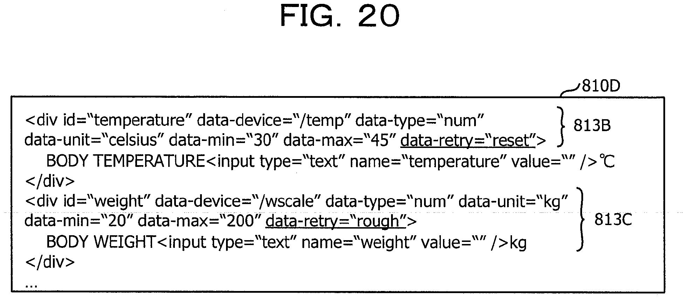

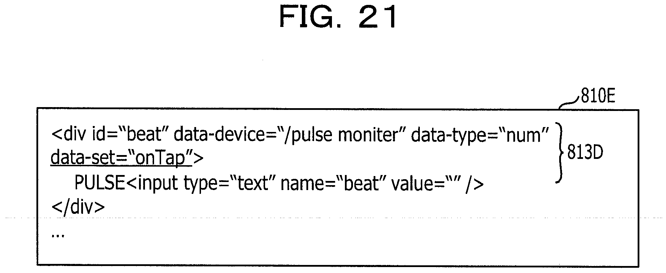

Next, another example of the usage condition will be described with reference to FIG. 20 and FIG. 21. FIG. 20 is a second diagram illustrating an example of screen definition information in which a usage condition is defined.

A description 820D illustrated in FIG. 20 illustrates screen definition information in a case where a clinical thermometer and an electronic scale (body weight scale) are used as the utilization equipments 200.

In a description 813B in the description 820D, the value of "data-unit" is "celsius" indicating Celsius, the value of "data-min" is "30", and the value of "data-max" is "45". In addition, in the description 813B, the value of "data-retry" is "reset". Therefore, at a time of reacquisition of data, the driver resets a corresponding one of the utilization equipments 200 once, thereby causing the corresponding one of the utilization equipments 200 to be coupled to the terminal device 100B again.

Note that, in the present embodiment, at a time of determination of the validity of data, performed by the validation unit 140, a history database in which previous data is stored may be referenced and the determination of the validity may be performed based on the previous data. In this case, in a case where it is determined that the data satisfies the usage condition and is in an appropriate range based on a past history, the validation unit 140 acquires the data. In this way, by referencing the past history, data that satisfies the usage condition and that is determined as appropriate is inhibited from being acquired. Therefore, a possibility that data in an appropriate range is acquired is increased.

The history database may be installed within, for example, the server device 300 or may be installed in another external device. The history database only has to be stored in a storage device accessible by the terminal device 100B.

In addition, in a description 813C in the description 820D, the value of "data-unit" is Kg, the value of "data-min" is "20", and the value of "data-max" is "200". In addition, in the description 813C, the value of "data-retry" is "rough". Therefore, at a time of reacquisition of data, the driver causes a measurement accuracy based on a corresponding one of the utilization equipments 200 to be decreased.

The reason is that, in, for example, the electronic scale, if continuing delicately moving, a measurement target object becomes unmeasurable, in some cases. Therefore, in the example of FIG. 20, at a time of reacquisition of data, the driver causes the measurement accuracy to be slightly loosened.

As described above, in the example of FIG. 20, the value of "data-unit", the value of "data-min", the value of "data-max", and the value of "data-retry" correspond to the usage condition.

FIG. 21 is a third diagram illustrating an example of screen definition information in which a usage condition is defined. A description 820E illustrated in FIG. 21 illustrates screen definition information in a case where a pulse monitor is used as one of the utilization equipments 200.

In a description 813D in the description 820E, the value of "data-set" is set to "onTap". Accordingly, in this case, data at a time of tapping a screen is acquired. In the example of FIG. 21, the value of "data-set" is the usage condition.

In the example of FIG. 21, in a case where it is possible to continuously acquire data from the corresponding one of the utilization equipments 200, or the like, a user of the terminal device 100B is able to acquire data at a timing of tapping a business form screen.

As described above, in the present embodiment, at a time of acquiring data that does not satisfy the usage condition, it is possible to cause the corresponding one of the utilization equipments 200 to perform a preliminarily specified operation. Therefore, the user of the terminal device 100B does not have to do works such as determining the validity of data by oneself and performing an operation for reacquisition of data by oneself.

### (Fourth Embodiment)

Hereinafter, a fourth embodiment will be described with reference to drawings. The fourth embodiment is different from the first embodiment in that a server that receives inputting of pieces of information such as an equipment descriptor, additional information, and a usage condition generates a business form application including the input pieces of information and distributes the business form application to a terminal device. Therefore, in the following description of the fourth embodiment, only differences from the first embodiment will be described, and the same symbol as a symbol used in the description of the first embodiment is assigned to a portion having the same functional configuration as that in the first embodiment, thereby omitting the description thereof.

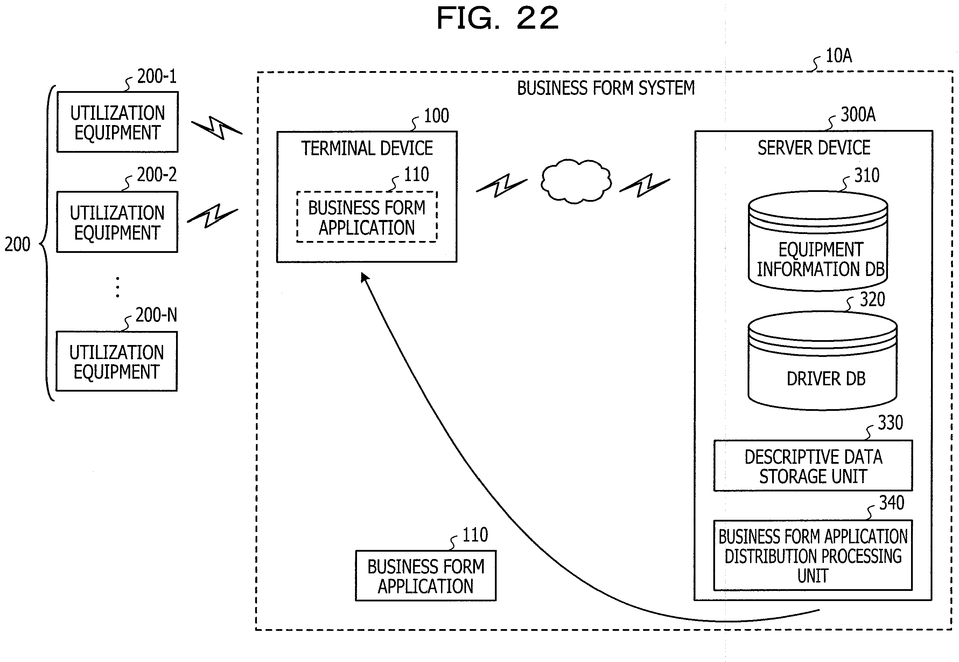

FIG. 22 is a diagram for explaining a system configuration of a business form system of a fourth embodiment. A business form system 10A of the present embodiment includes the terminal device 100 and a server device 300A.

In the business form system 10A of the present embodiment, the server device 300A includes the equipment information database 310, the driver database 320, a descriptive data storage unit 330, and a business form application distribution processing unit 340.

The descriptive data storage unit 330 saves descriptive data to serve as a pattern of a business form application.

Upon receiving inputting of an equipment descriptor of one of the utilization equipments 200 included in screen definition information, the business form application distribution processing unit 340 inserts the equipment descriptor into a description indicated by descriptive data and puts the descriptive data into the business form application 110 corresponding to the corresponding one of the utilization equipments 200, thereby distributing the business form application 110 to the terminal device 100.

Note that while, in the server device 300A of the present embodiment, a configuration including the equipment information database 310, the driver database 320, the descriptive data storage unit 330, and the business form application distribution processing unit 340 is adopted, a configuration is not limited to this. Each database may be installed in a device other than the server device 300A, for example.

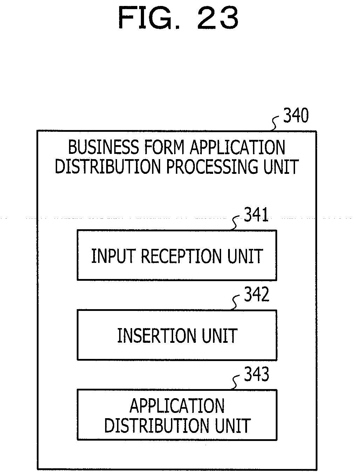

FIG. 23 is a diagram for explaining functions of a business form application distribution unit included in a server device of the fourth embodiment.

The business form application distribution processing unit 340 of the present embodiment includes an input reception unit 341, an insertion unit 342, and an application distribution unit 343.

The input reception unit 341 receives inputting of an equipment descriptor from, for example, an administrator or the like of the business form system 10A. The inputting of an equipment descriptor may be performed by an editor or the like preliminarily included in the server device 300A, for example.

The insertion unit 342 inserts the equipment descriptor received by the input reception unit 341, into descriptive data held by the descriptive data storage unit 330.

Specifically, in the descriptive data storage unit 330 of the present embodiment, descriptive data in a state in which no equipment descriptor is described is held by the description 810 included in the description 800, for example (see FIG. 8). In a case where the input reception unit 341 receives the inputting of an equipment descriptor, the insertion unit 342 inserts the input equipment descriptor into a point into which the equipment descriptor is to be inserted in the descriptive data.

In the present embodiment, by the equipment descriptor being inserted, the description 800 is completed, and the business form application 110 in which data of the utilization equipment 200 specified by the equipment descriptor is able to be automatically input is obtained.

The application distribution unit 343 distributes the completed business form application 110 to the terminal device 100. The terminal device 100 to serve as a distribution destination may be preliminarily specified or may be the terminal device 100 that requests to download the business form application 110. In addition, a timing at which the application distribution unit 343 distributes the business form application 110 may be a time of receiving an acquisition request for the business form application 110 from the terminal device 100 or may be a time of completion of insertion of the equipment descriptor performed by the insertion unit 342.

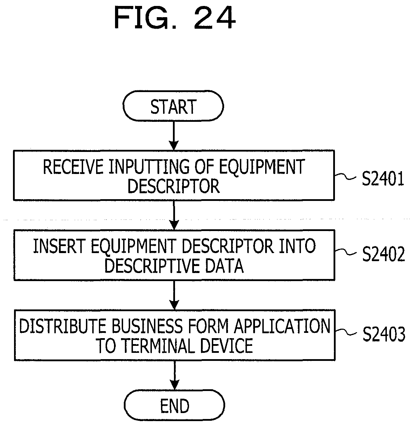

FIG. 24 is a flowchart for explaining processing in a business form application distribution processing unit of the fourth embodiment.

Upon receiving inputting of an equipment descriptor by using the input reception unit 341, the business form application distribution processing unit 340 of the present embodiment passes the received equipment descriptor to the insertion unit 342 (step S2401). Subsequently, by using the insertion unit 342, the business form application distribution processing unit 340 inserts the received equipment descriptor into an insertion point of descriptive data held by the descriptive data storage unit 330 (step S2402).

Subsequently, by using the application distribution unit 343, the business form application distribution processing unit 340 distributes, to the terminal device 100, the business form application 110 into which the equipment descriptor is inserted (step S2403), and terminates the processing.

Note that while the present embodiment is described under the assumption that the equipment descriptor is input to the server device 300A, there is no limitation to this. In addition to the equipment descriptor, the server device 300A may receive inputting of a description indicating the additional information explained in the above-mentioned embodiment, a description indicating the usage condition, a description indicating processing caused to be executed by a driver after acquiring the driver, and so forth and may insert these into the descriptive data.

The present disclosure is not limited to the specifically disclosed embodiments and may be variously altered or modified without departing from the scope of claims. The claims define the scope of the invention.

## Claims

1. An information processing device (100) comprising:
a processing unit (15) configured to:
extract screen definition information of a business form from a screen definition information describing unit (120), wherein the screen definition information includes an equipment descriptor (121) and wherein the equipment descriptor (121) is associated with an input field in the business form;
search for an equipment (200) indicated by the equipment descriptor (121);
discover the equipment (200) to be coupled to the information processing device, based on the equipment descriptor (121), wherein the equipment (200) is located around the information processing device (100);
couple the discovered equipment (200) to the information processing device (100);
acquire data from the equipment (200); and
insert, into the input field, the data acquired from the equipment (200).

2. The information processing device (100) according to claim 1, wherein
the processing unit (15) is further configured to:
identify, based on additional information included in the screen definition information of the business form, the input field into which the data is to be inserted in the business form; and
perform processing for acquiring, from the equipment (200), a value indicated by the additional information.

3. The information processing device (100) according to claim 1 or 2, wherein
the processing unit (15) is further configured to:
determine, based on a usage condition included in the screen definition information of the business form, whether the data satisfies the usage condition; and
perform processing for causing a specified operation to be performed in the equipment (200), in a case where the data does not satisfy the usage condition.

4. The information processing device (100) according to any preceding claim, wherein the processing unit (15) is further configured to acquire an equipment control module corresponding to the equipment (200) and dynamically inject the equipment control module into the information processing device (100).

5. The information processing device (100) according to claim 4, wherein the equipment control module is stored in a driver database (320).

6. The information processing device (100) according to claim 4 or 5, wherein the processing unit (15) is further configured to transmit an equipment control instruction to the equipment (200) using the equipment control module and acquire the data from the equipment (200) in response to the equipment control instruction.

7. An information processing method executed by an information processing device (100), the method comprising:
extracting screen definition information of a business form from a screen definition information describing unit (120), wherein the screen definition information includes an equipment descriptor (121) and wherein the equipment descriptor (121) is associated with an input field in the business form;
searching for an equipment (200) indicated by the equipment descriptor (121);
discovering an equipment (200) to be coupled to the information processing device (100), based on the equipment descriptor (121), wherein the equipment (200) is located around the information processing device (100);
coupling the discovered equipment (200) to the information processing device (100);
acquiring data from the equipment (200); and
inserting, into the input field, the data acquired from the equipment (200).

8. An information processing program which, when executed on a computer causes the computer to carry out the information processing method according to claim 7.

## Patentansprüche

1. Informationsverarbeitungsvorrichtung (100) umfassend:
eine Verarbeitungseinheit (15), die konfiguriert ist, um:
Bildschirmdefinitionsinformationen einer Geschäftsform aus einer Bildschirmdefinitionsinformationsbeschreibungseinheit (120) zu extrahieren, wobei die Bildschirmdefinitionsinformationen einen Gerätebeschreiber (121) umfassen und wobei der Gerätebeschreiber (121) mit einem Eingabefeld in der Geschäftsform verknüpft ist;
nach einem Gerät (200) zu suchen, das durch den Gerätebeschreiber (121) angegeben wird;
das Gerät (200) zu entdecken, das mit der Informationsverarbeitungsvorrichtung zu koppeln ist, basierend auf dem Gerätebeschreiber (121), wobei sich das Gerät (200) um die Informationsverarbeitungsvorrichtung (100) herum befindet;
das entdeckte Gerät (200) mit der Informationsverarbeitungsvorrichtung (100) zu koppeln;
Daten von dem Gerät (200) zu erfassen; und
in das Eingabefeld die Daten einzugeben, die von dem Gerät (200) erfasst werden.

2. Informationsverarbeitungsvorrichtung (100) nach Anspruch 1, wobei die Verarbeitungseinheit (15) ferner konfiguriert ist, um:
basierend auf zusätzlichen Informationen, die in den Bildschirmdefinitionsinformationen der Geschäftsform enthalten sind, das Eingabefeld zu kennzeichnen, in welches die Daten in der Geschäftsform einzugeben sind; und
eine Verarbeitung zum Erfassen von dem Gerät (200) eines Werts, der durch die zusätzlichen Informationen angegeben wird, durchzuführen.

3. Informationsverarbeitungsvorrichtung (100) nach Anspruch 1 oder 2, wobei die Verarbeitungseinheit (15) ferner konfiguriert ist, um:
basierend auf einer Nutzungsbedingung, die in den Bildschirmdefinitionsinformationen der Geschäftsform enthalten ist, zu bestimmen, ob die Daten die Nutzungsbedingung erfüllen; und
eine Verarbeitung durchzuführen, um zu bewirken, dass eine bestimmte Operation in dem Gerät (200) durchgeführt wird in einem Fall, wo die Daten die Nutzungsbedingung nicht erfüllen.

4. Informationsverarbeitungsvorrichtung (100) nach einem der vorherigen Ansprüche, wobei die Verarbeitungseinheit (15) ferner konfiguriert ist, um ein Gerätesteuermodul entsprechend dem Gerät (200) zu erfassen und das Gerätesteuermodul dynamisch in die Informationsverarbeitungsvorrichtung (100) einzugeben.

5. Informationsverarbeitungsvorrichtung (100) nach Anspruch 4, wobei das Gerätesteuermodul in einer Treiberdatenbank (320) gespeichert ist.

6. Informationsverarbeitungsvorrichtung (100) nach Anspruch 4 oder 5, wobei die Verarbeitungseinheit (15) ferner konfiguriert ist, um einen Gerätesteuerbefehl unter Verwendung des Gerätesteuermoduls zu dem Gerät (200) zu senden und die Daten von dem Gerät (200) als Reaktion auf den Gerätesteuerbefehl zu erfassen.

7. Informationsverarbeitungsverfahren, das von einer Informationsverarbeitungsvorrichtung (100) ausgeführt wird, wobei das Verfahren Folgendes umfasst:
Extrahieren von Bildschirmdefinitionsinformationen einer Geschäftsform aus einer Bildschirmdefinitionsinformationsbeschreibungseinheit (120), wobei die Bildschirmdefinitionsinformationen einen Gerätebeschreiber (121) umfassen und wobei der Gerätebeschreiber (121) mit einem Eingabefeld in der Geschäftsform verknüpft ist;
Suchen nach einem Gerät (200), das durch den Gerätebeschreiber (121) angegeben wird;
Entdecken eines Geräts (200), das mit der Informationsverarbeitungsvorrichtung (100) zu koppeln ist, basierend auf dem Gerätebeschreiber (121), wobei sich das Gerät (200) um die Informationsverarbeitungsvorrichtung (100) herum befindet;
Koppeln des entdeckten Geräts (200) mit der Informationsverarbeitungsvorrichtung (100);
Erfassen von Daten von dem Gerät (200); und
Eingeben in das Eingabefeld der Daten, die von dem Gerät (200) erfasst wurden.

8. Informationsverarbeitungsprogramm, welches, wenn es auf einem Computer ausgeführt wird, bewirkt, dass der Computer das Informationsverarbeitungsverfahren nach Anspruch 7 ausführt.

## Revendications

1. Dispositif de traitement d'informations (100) comprenant :
une unité de traitement (15) configurée pour :
extraire des informations de définition d'écran d'un formulaire commercial à partir d'une unité de description d'informations de définition d'écran (120), dans lequel les informations de définition d'écran comprennent un descripteur d'équipement (121) et dans lequel le descripteur d'équipement (121) est associé à un champ d'entrée dans le formulaire commercial ;
rechercher un équipement (200) indiqué par le descripteur d'équipement (121) ;
découvrir l'équipement (200) à coupler au dispositif de traitement d'informations, sur la base du descripteur d'équipement (121), dans lequel l'équipement (200) est situé autour du dispositif de traitement d'informations (100) ;
coupler l'équipement découvert (200) au dispositif de traitement d'informations (100) ;
acquérir des données à partir de l'équipement (200) ; et
insérer, dans le champ de saisie, les données acquises à partir de l'équipement (200).

2. Dispositif de traitement d'informations (100) selon la revendication 1, dans lequel
l'unité de traitement (15) est en outre configurée pour :
identifier, sur la base d'informations supplémentaires incluses dans les informations de définition d'écran du formulaire commercial, le champ d'entrée dans lequel les données doivent être insérées dans le formulaire commercial ; et
effectuer un traitement pour acquérir, à partir de l'équipement (200), une valeur indiquée par les informations supplémentaires.

3. Dispositif de traitement d'informations (100) selon la revendication 1 ou 2, dans lequel
l'unité de traitement (15) est en outre configurée pour :
déterminer, sur la base d'une condition d'utilisation incluse dans les informations de définition d'écran du formulaire commercial, si les données satisfont à la condition d'utilisation ; et
effectuer un traitement pour amener une opération spécifiée à être effectuée dans l'équipement (200), dans un cas où les données ne satisfont pas à la condition d'utilisation.

4. Dispositif de traitement d'informations (100) selon l'une quelconque des revendications précédentes, dans lequel l'unité de traitement (15) est en outre configurée pour acquérir un module de commande d'équipement correspondant à l'équipement (200) et injecter de manière dynamique le module de commande d'équipement dans le dispositif de traitement d'informations (100).

5. Dispositif de traitement d'informations (100) selon la revendication 4, dans lequel le module de commande d'équipement est stocké dans une base de données de pilotes (320).

6. Dispositif de traitement d'informations (100) selon la revendication 4 ou 5, dans lequel l'unité de traitement (15) est en outre configurée pour transmettre une instruction de commande d'équipement à l'équipement (200) en utilisant le module de commande d'équipement et acquérir les données à partir de l'équipement (200) en réponse à l'instruction de commande d'équipement.

7. Procédé de traitement d'informations exécuté par un dispositif de traitement d'informations (100), le procédé comprenant les étapes consistant à :
extraire des informations de définition d'écran d'un formulaire commercial à partir d'une unité de description d'informations de définition d'écran (120), dans lequel les informations de définition d'écran comprennent un descripteur d'équipement (121) et dans lequel le descripteur d'équipement (121) est associé à un champ d'entrée dans le formulaire commercial ;
rechercher un équipement (200) indiqué par le descripteur d'équipement (121) ;
découvrir un équipement (200) à coupler au dispositif de traitement d'informations (100), sur la base du descripteur d'équipement (121), dans lequel l'équipement (200) est situé autour du dispositif de traitement d'informations (100) ;
coupler l'équipement découvert (200) au dispositif de traitement d'informations (100) ;
acquérir des données à partir de l'équipement (200) ; et
insérer, dans le champ d'entrée, les données acquises à partir de l'équipement (200).

8. Programme de traitement d'informations qui, lorsqu'il est exécuté sur un ordinateur, amène l'ordinateur à exécuter le procédé de traitement d'informations selon la revendication 7.
